# EUROPÄISCHE PATENTANMELDUNG

(11) **EP 4 845 016 A1**
(43) Veröffentlichungstag der Anmeldung: **25.11.2026**
(21) Anmeldenummer: 26179751.8
(22) Anmeldetag: 20.05.2026
(51) Int. Cl.: H02M 7/5395, H01G 4/40, H01G 4/224, H02G 5/00, H02M 1/44, H02M 7/00, H05K 7/14

(54) **ZWISCHENKREISKONDENSATORANORDNUNG UND VERFAHREN ZUM BETREIBEN EINER ZWISCHENKREISKONDENSATORANORDNUNG**

(30) Priorität: 21.05.2025 DE 102025119892
(71) Anmelder: Volkswagen Aktiengesellschaft, 38440 Wolfsburg (DE)
(72) Erfinder: Sommer, Christian, 38440 Wolfsburg (DE); Reinhard, Julian, 38440 Wolfsburg (DE)
(74) Vertreter: Patentanwälte Bressel und Partner mbB

(57) **Zusammenfassung**

Die Erfindung betrifft einen Zwischenkreiskondensatoranordnung (1), umfassend mindestens einen X-Kondensator (CX), mindestens ein Paar (4) Y-Kondensatoren (CY), eine Plus-Stromschiene (2) und eine Minus-Stromschiene (3), wobei der mindestens eine X-Kondensator (CX) mit der Plus-Stromschiene (2) und der Minus-Stromschiene (3) elektrisch verbunden ist, und wobei das mindestens eine Paar (4) Y-Kondensatoren (CY) aneinander gestapelt zwischen den Stromschienen (2,3) angeordnet ist, wobei einer der Y-Kondensatoren (CY) des mindestens einen Paares (4) mit der Plus-Stromschiene (2) und ein anderer der Y-Kondensatoren (CY) des mindestens einen Paares (4) mit der Minus-Stromschiene (3) elektrisch verbunden ist, und wobei eine jeweilige andere Seite der Y-Kondensatoren (CY) des mindestens einen Paares (4) mit jeweils einer Massestromschiene (5,6) elektrisch verbunden ist. Ferner betrifft die Erfindung ein Verfahren zum Betreiben einer Zwischenkreiskondensatoranordnung (1).

## Beschreibung

Die Erfindung betrifft eine Zwischenkreiskondensatoranordnung und ein Verfahren zum Betreiben einer Zwischenkreiskondensatoranordnung. Ferner betrifft die Erfindung eine leistungselektronische Anordnung.

Die beim Schalten von Leistungshalbleitern entstehenden Gleichtaktströme, das heißt Ströme, die von DC+ und DC- gleichsinnig gegen Masse fließen (auch Common-Mode-Ströme genannt) und die hiermit einhergehenden EMV-Störungen begrenzen eine einstellbare Schaltgeschwindigkeit der Leistungshalbleiter und somit eine erreichbare Effizienz eines Pulswechselrichters. Ein übergeordnetes Ziel ist daher eine Filterung der Common-Mode-Ströme nahe an den Leistungshalbleitern. Hierzu werden in der Regel EMV-Filter verwendet.

Die DE 10 2018 208 308 A1 beschreibt eine modular aufgebaute Filtervorrichtung für Störungen, insbesondere Gleich- und Gegentaktstörungen eines Stromrichters wie einem Pulswechselrichter. Die Entwärmung der Bauelemente für die Filtervorrichtung erfolgt hierbei mittels einer Kühleinrichtung, die auch für die Entwärmung der leistungselektronischen Komponenten des Stromrichters vorgesehen ist. Auf diese Weise kann eine effiziente Entwärmung der Bauelemente der Filtervorrichtung bei geringem Material- und Volumenbedarf erreicht werden.

Der Erfindung liegt die Aufgabe zu Grunde, eine verbesserte Lösung zum Filtern von Gleichtaktströmen anzugeben.

Die Aufgabe wird erfindungsgemäß durch eine Zwischenkreiskondensatoranordnung mit den Merkmalen des Patentanspruchs 1 und ein Verfahren mit den Merkmalen des Patentanspruchs 11 gelöst. Vorteilhafte Ausgestaltungen der Erfindung ergeben sich aus den Unteransprüchen.

Insbesondere wird eine Zwischenkreiskondensatoranordnung geschaffen, umfassend mindestens einen X-Kondensator, mindestens ein Paar Y-Kondensatoren, eine Plus-Stromschiene und eine Minus-Stromschiene, wobei der mindestens eine X-Kondensator mit der Plus-Stromschiene und der Minus-Stromschiene elektrisch verbunden ist, und wobei das mindestens eine Paar Y-Kondensatoren aneinander gestapelt zwischen den Stromschienen angeordnet ist, wobei einer der Y-Kondensatoren des mindestens einen Paares mit der Plus-Stromschiene und ein anderer der Y-Kondensatoren des mindestens einen Paares mit der Minus-Stromschiene elektrisch verbunden ist, und wobei eine jeweilige andere Seite der Y-Kondensatoren des mindestens einen Paares mit jeweils einer Massestromschiene elektrisch verbunden ist.

Ferner wird insbesondere ein Verfahren zum Betreiben einer Zwischenkreiskondensatoranordnung zur Verfügung gestellt, wobei mindestens ein X-Kondensator elektrisch verbunden mit einer Plus-Stromschiene und einer Minus-Stromschiene betrieben wird, und wobei mindestens ein Paar Y-Kondensatoren aneinander gestapelt zwischen den Stromschienen angeordnet betrieben wird, wobei einer der Y-Kondensatoren des mindestens einen Paares mit der Plus-Stromschiene und ein anderer der Y-Kondensatoren des mindestens einen Paares mit der Minus-Stromschiene elektrisch verbunden ist, und wobei eine jeweilige andere Seite der Y-Kondensatoren des mindestens einen Paares mit jeweils einer Massestromschiene elektrisch verbunden ist.

Die Zwischenkreiskondensatoranordnung und das Verfahren ermöglichen es, durch Gleichtaktströme hervorgerufene Störungen verbessert herauszufiltern. Eine der Grundideen ist hierbei, Y-Kondensatoren nicht separat in einem EMV-Filter anzuordnen, sondern in der Nähe von mindestens einem X-Kondensator, der als Zwischenkreiskondensator eingesetzt wird, beispielsweise in einem Antriebstrang von einem Elektro- oder Hybridfahrzeug. Hierdurch kann eine Filterung der durch Gleichtaktströme hervorgerufenen Störungen verbessert werden. In der vorgeschlagenen Zwischenkreiskondensatoranordnung ist hierzu mindestens ein X-Kondensator vorgesehen. Insbesondere sind mehrere parallel geschaltete X-Kondensatoren vorgesehen. Ferner ist mindestens ein Paar Y-Kondensatoren vorgesehen. Die Zwischenkreiskondensatoranordnung umfasst weiter eine Plus-Stromschiene und eine Minus-Stromschiene, wobei der mindestens eine X-Kondensator mit der Plus-Stromschiene und der Minus-Stromschiene elektrisch verbunden ist. Das mindestens eine Paar Y-Kondensatoren ist aneinander gestapelt zwischen den Stromschienen angeordnet, wobei einer der Y-Kondensatoren des mindestens einen Paares mit der Plus-Stromschiene und ein anderer der Y-Kondensatoren des mindestens einen Paares mit der Minus-Stromschiene elektrisch verbunden ist. Eine jeweilige andere Seite der Y-Kondensatoren des mindestens einen Paares ist mit jeweils einer Massestromschiene elektrisch verbunden.

Die Plus- und Minus-Stromschienen und die Massestromschienen sind insbesondere nach außen (aus einem Gehäuse) herausgeführt, sodass diese in geeigneter Weise kontaktiert werden können, insbesondere mit DC+ und DC- bzw. einer Masse.

Die Zwischenkreiskondensatoranordnung ist insbesondere für einen Einsatz im Bereich der Leistungselektronik vorgesehen und ausgebildet. Insbesondere wird oder ist die Zwischenkreiskondensatoranordnung über die Plus- und Minus-Stromschienen mit DC+ und DC- sowie Leistungsmodulen (mit jeweiligen Leistungshalbleiterschaltern) elektrisch verbunden. Die Leistungsmodule bilden beispielsweise jeweils eine Halbbrücke eines Pulswechselrichters aus bzw. stellen jeweils eine solche Halbbrücke bereit. Ein beispielhaft genannter Einsatzbereich ist ein Antriebsstrang eines Elektro- oder Hybridfahrzeugs, in dem die Zwischenkreiskondensatoranordnung insbesondere zwischen einer Hochvoltbatterie und einem Stromrichter, insbesondere einem Pulswechselrichter, angeordnet ist.

Ein X-Kondensator ist insbesondere ein Klasse-X-Kondensator nach IEC 60384-14 in der am Anmeldetag gültigen Fassung. Ein Y-Kondensator ist insbesondere ein Klasse-Y-Kondensator nach IEC 60384-14 in der am Anmeldetag gültigen Fassung.

Die Zwischenkreiskondensatoranordnung weist insbesondere auch ein Gehäuse auf, in dem der mindestens eine X-Kondensator und die Y-Kondensatoren gehaust sind.

In einer Ausführungsform ist vorgesehen, dass eine Anordnung der Y-Kondensatoren des mindestens einen Paares zwischen den Plus- und Minusstromschienen symmetrisch ist. Hierdurch wird erreicht, dass eine Weglänge von einem Leistungsmodul über die Plus-Stromschiene und den elektrisch hiermit verbundenen Y-Kondensator des mindestens einen Paares und eine Weglänge von dem Leistungsmodul über die Minus-Stromschiene und den elektrisch hiermit verbundenen Y-Kondensator des mindestens einen Paares gleich ist, wodurch sich durch Gleichtaktströme hervorgerufene Störungen verbessert herausfiltern lassen.

In einer Ausführungsform ist vorgesehen, dass die aneinander gestapelten Y-Kondensatoren des mindestens einen Paares in einer von der Plus-Stromschiene zur Minus-Stromschiene verlaufenden Erstreckungsrichtung zusammen die gleiche Größe aufweisen wie der mindestens eine X-Kondensator. Hierdurch kann eine besonderes raumsparende und/oder effiziente Anbindung der Y-Kondensatoren an die Plus- und Minus-Stromschienen erfolgen. Ferner wird hierdurch insbesondere auch die voranstehend beschriebene Symmetrie unterstützt.

In einer Ausführungsform ist vorgesehen, dass das mindestens eine Paar Y-Kondensatoren direkt benachbart zu dem mindestens einen X-Kondensator angeordnet ist. Hierdurch kann eine besonderes raumsparende und/oder effiziente Anbindung der Y-Kondensatoren an die Plus-und Minus-Stromschienen erfolgen.

In einer Ausführungsform ist vorgesehen, dass zwei Paare Y-Kondensatoren vorgesehen sind, wobei je eines der Paare an einem der Enden der Plus- und Minus-Stromschienen angeordnet ist. Hierdurch kann ein Strompfad für Gleichtaktströme bei mehreren an den Plus- und Minus-Stromschienen angeordneten Leistungsmodulen von jedem der Leistungsmodule zu den Y-Kondensatoren möglichst kurz gehalten werden. Hierdurch kann das Filtern von durch die Gleichtaktströme hervorgerufenen Störungen weiter verbessert werden.

In einer Ausführungsform ist vorgesehen, dass die Massestromschiene des einen der Y-Kondensatoren des mindestens einen Paares mit der Massestromschiene des anderen der Y-Kondensatoren des mindestens einen Paares verschweißt ist, wobei nur die Massestromschiene des anderen Y-Kondensators nach außen geführt ist. Hierdurch kann Material für die Massestromschiene eingespart werden. Ferner muss nur eine der Massestromschienen nach außen geführt werden.

In einer Ausführungsform ist vorgesehen, dass die Massestromschienen der Y-Kondensatoren des mindestens einen Paares parallel zueinander nach außen geführt sind. Hierdurch kann insbesondere auf ein Verschweißen der Massestromschienen verzichtet werden, was einen Aufwand bei der Herstellung reduziert.

In einer Ausführungsform ist vorgesehen, dass die Y-Kondensatoren in einer Richtung parallel zu einer Längserstreckungsrichtung der Plus- und Minusstromschienen eine geringere Größe aufweisen als senkrecht hierzu. Hierdurch kann ein besonders kompakter und raumsparender Aufbau der Zwischenkreiskondensatoranordnung geschaffen werden. Da in der Regel die X-Kondensatoren im Bereich der Leistungselektronik insbesondere größer sind als die Y-Kondensatoren ist eine derartige Ausgestaltung möglich.

In einer Ausführungsform ist vorgesehen, dass der mindestens eine X-Kondensator und das mindestens eine Paar Y-Kondensatoren in einem gemeinsamen Kunststoffgehäuse gehaust sind und/oder mit Epoxidharz vergossen sind. Hierdurch kann insbesondere ein kompakter und einstückiger Baustein geschaffen werden, der eine Handhabung und/oder eine Montage in einem Anwendungsszenario, beispielsweise in einem Antriebsstrang eines Elektro- oder Hybridfahrzeugs, vereinfacht. Ferner sind die Kondensatoren durch das Vergießen sicher in dem Gehäuse fixiert.

Es wird ferner auch eine leistungselektronische Anordnung geschaffen, umfassend eine Zwischenkreiskondensatoranordnung nach einer der beschriebenen Ausführungsformen, und mindestens ein Leistungsmodul, wobei das mindestens eine Leistungsmodul zwischen den Enden der Plus-Stromschiene und der Minus-Stromschiene angeordnet ist und mit der Plus-Stromschiene und der Minus-Stromschiene elektrisch verbunden ist. Insbesondere sind mindestens drei Leistungsmodule, insbesondere zum Bereitstellen von drei Halbbrücken, vorgesehen.

Nachfolgend wird die Erfindung anhand bevorzugter Ausführungsbeispiele unter Bezugnahme auf die Figuren näher erläutert. Hierbei zeigen:
- Fig. 1: eine schematische Darstellung von Ausführungsformen der Zwischenkreiskondensatoranordnung;
- Fig. 2: eine schematische Darstellung zur Verdeutlichung einer Ausführungsform der Zwischenkreiskondensatoranordnung;
- Fig. 3: eine schematische Darstellung einer Ausführungsform der Zwischenkreiskondensatoranordnung.

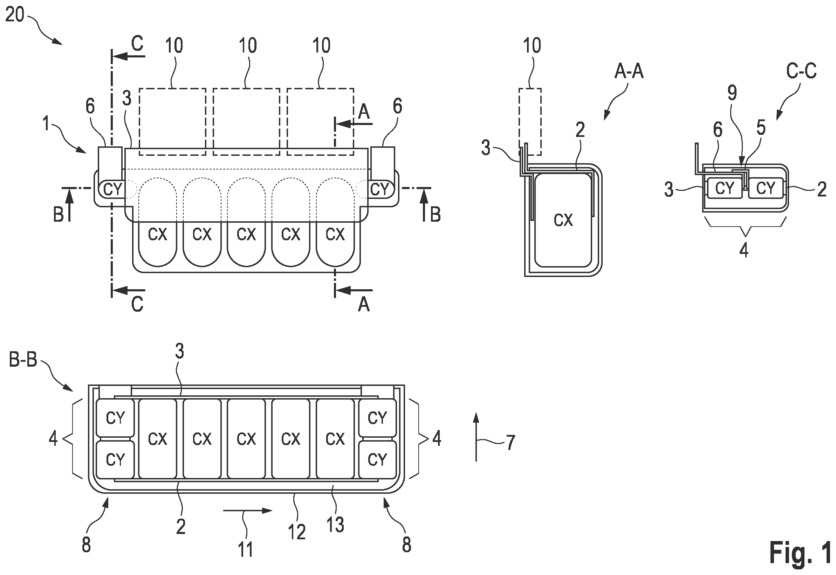

Die Fig. 1 zeigt eine schematische Darstellung von Ausführungsformen der Zwischenkreiskondensatoranordnung 1. Gezeigt sind eine Draufsicht sowie mehrere Schnitte A-A, B-B, C-C durch die Zwischenkreiskondensatoranordnung 1.

Die Zwischenkreiskondensatoranordnung 1 umfasst in den gezeigten Ausführungsformen insbesondere eine Mehrzahl von X-Kondensatoren CX, die nebeneinander angeordnet sind. Die X-Kondensatoren CX sind jeweils mit einer Plus-Stromschiene 2 und einer Minus-Stromschiene 3 der Zwischenkreiskondensatoranordnung 1 elektrisch verbunden und somit parallel zueinander geschaltet. Die Stromschienen 2, 3 dienen insbesondere auch dem Herstellen eines Kontaktes zu DC+ und DC- und zu Leistungsmodulen 10, welche insbesondere benachbart zu den Stromschienen 2, 3 entlang einer Längserstreckungsrichtung 11 zwischen Enden 8 der Stromschienen 2, 3 angeordnet sind oder angeordnet werden können. Hierzu werden die Stromschienen 2, 3 insbesondere in einer Richtung senkrecht zu der Längserstreckungsrichtung 11 aus einem Gehäuse 12 herausgeführt (vgl. auch Schnitt A-A).

Ferner umfasst die Zwischenkreiskondensatoranordnung 1 insbesondere zwei Paare 4 Y-Kondensatoren CY, wobei die Y-Kondensatoren CY jeden Paares 4 aneinander gestapelt zwischen den Stromschienen 2, 3 angeordnet sind. Je eines der Paare 4 ist insbesondere an einem der Enden 8 der Plus- und Minus-Stromschienen 2, 3 angeordnet.

Einer der Y-Kondensatoren CY eines jeden Paares 4 ist mit der Plus-Stromschiene 2 und ein anderer der Y-Kondensatoren eines jeden Paares 4 ist mit der Minus-Stromschiene 3 elektrisch verbunden. Eine jeweilige andere Seite der Y-Kondensatoren CY der Paare 4 ist mit jeweils einer Massestromschiene 5, 6 elektrisch verbunden. Insbesondere sind auf einer der Seiten jeweilige elektrische Anschlusskontakte der Y-Kondensatoren CY der Plus-Stromschiene 2 bzw. der Minus-Stromschiene 3 zugewandt. Die jeweils anderen Kontaktseiten der Y-Kondensatoren CY eines jeden Paares 4 sind einander zugewandt.

In der gezeigten Ausführungsform ist insbesondere vorgesehen, dass eine Anordnung der Y-Kondensatoren CY der Paare 4 zwischen den Plus- und Minusstromschienen 2, 3 symmetrisch ist.

Ferner ist in der gezeigten Ausführungsform insbesondere vorgesehen, dass die aneinander gestapelten Y-Kondensatoren CY der Paare 4 in einer von der Plus-Stromschiene 2 zur Minus-Stromschiene 3 verlaufenden Erstreckungsrichtung 7 zusammen die gleiche Größe aufweisen wie die X-Kondensatoren CX.

Darüber hinaus ist insbesondere vorgesehen, dass die Paare 4 Y-Kondensatoren CY direkt benachbart zu dem jeweils äußersten der Mehrzahl der X-Kondensatoren CX angeordnet sind.

Bei der gezeigten Ausführungsform ist ferner insbesondere vorgesehen, dass die Massestromschiene 5 des einen der Y-Kondensatoren CY der Paare 4 mit der Massestromschiene 6 des anderen der Y-Kondensatoren CY der Paare 4 verschweißt ist, wobei nur die Massestromschiene 6 des anderen Y-Kondensators CY nach außen geführt ist (vgl. Schnitt C-C). Insbesondere ist hierzu im Bereich zwischen den Y-Kondensatoren CY jeden Paares 4 eine Schweißverbindung 9 zwischen den Massestromschienen 5, 6 ausgeführt.

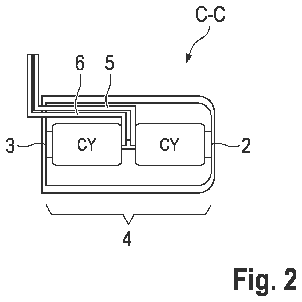

Die Fig. 2 zeigt eine schematische Darstellung zur Verdeutlichung einer Ausführungsform der Zwischenkreiskondensatoranordnung 1. Die Ausführungsform ist grundsätzlich wie die in der Fig 1 gezeigte Ausführungsform ausgebildet, gleiche Bezugszeichen bezeichnen gleiche Merkmale und Begriffe. Bei dieser Ausführungsform ist vorgesehen, dass die Massestromschienen 5, 6 der Y-Kondensatoren CY der Paare 4 parallel zueinander nach außen geführt sind.

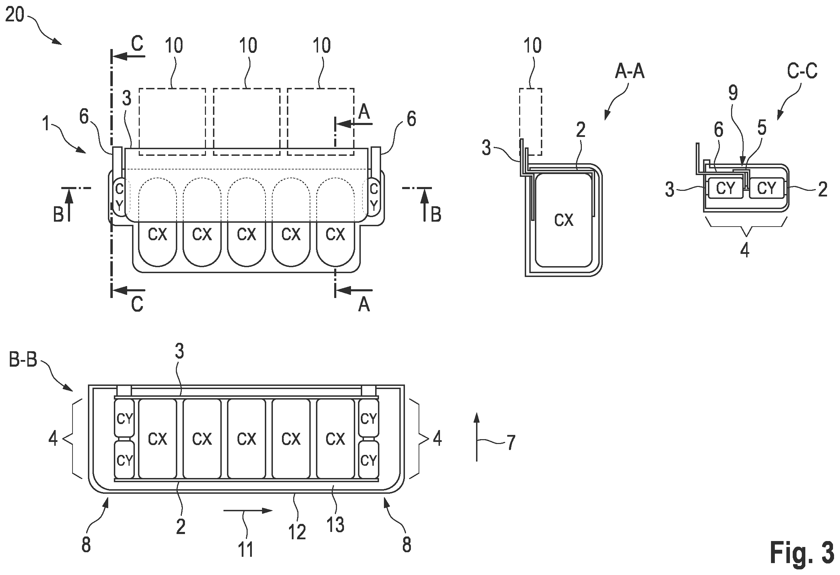

Die Fig. 3 zeigt eine schematische Darstellung einer Ausführungsform der Zwischenkreiskondensatoranordnung 1. Die Ausführungsform ist grundsätzlich wie die in der Fig 1 gezeigte Ausführungsform ausgebildet, gleiche Bezugszeichen bezeichnen gleiche Merkmale und Begriffe. Bei dieser Ausführungsform ist vorgesehen, dass die Y-Kondensatoren CY in einer Richtung parallel zu einer Längserstreckungsrichtung 11 der Plus-und Minusstromschienen 2, 3 eine geringere Größe aufweisen als senkrecht hierzu.

Bei allen gezeigten Ausführungsformen ist insbesondere vorgesehen, dass die X-Kondensatoren CX und die Paare 4 Y-Kondensatoren CY in einem gemeinsamen Kunststoffgehäuse 12 gehaust sind und insbesondere mit Epoxidharz 13 vergossen sind.

Die Figuren zeigen ferner auch eine leistungselektronische Anordnung 20, umfassend eine Zwischenkreiskondensatoranordnung 1 nach einer der beschriebenen Ausführungsformen und die Leistungsmodule 10, wobei die Leistungsmodule 10 zwischen den Enden 8 der Plus-Stromschiene 2 und der Minus-Stromschiene 3 angeordnet sind und mit der Plus-Stromschiene 2 und der Minus-Stromschiene 3 elektrisch verbunden sind.

### Bezugszeichenliste

- 1: Zwischenkreiskondensatoranordnung
- 2: Plus-Stromschiene
- 3: Minus-Stromschiene
- 4: Paar
- 5: Massestromschiene
- 6: Massestromschiene
- 7: Erstreckungsrichtung
- 8: Ende
- 9: Schweißverbindung
- 10: Leistungsmodul
- 11: Längserstreckungsrichtung
- 12: Kunststoffgehäuse
- 13: Epoxidharz
- 20: leistungselektronische Anordnung
- A-A: Schnitt durch die Zwischenkreiskondensatoranordnung
- B-B: Schnitt durch die Zwischenkreiskondensatoranordnung
- C-C: Schnitt durch die Zwischenkreiskondensatoranordnung
- CX: X-Kondensator
- CY: Y-Kondensator

## Patentansprüche

1. Zwischenkreiskondensatoranordnung (1), umfassend:
mindestens einen X-Kondensator (CX),
mindestens ein Paar (4) Y-Kondensatoren (CY),
eine Plus-Stromschiene (2) und eine Minus-Stromschiene (3),
wobei der mindestens eine X-Kondensator (CX) mit der Plus-Stromschiene (2) und der Minus-Stromschiene (3) elektrisch verbunden ist, und
wobei das mindestens eine Paar (4) Y-Kondensatoren (CY) aneinander gestapelt zwischen den Stromschienen (2,3) angeordnet ist,
wobei einer der Y-Kondensatoren (CY) des mindestens einen Paares (4) mit der Plus-Stromschiene (2) und ein anderer der Y-Kondensatoren (CY) des mindestens einen Paares (4) mit der Minus-Stromschiene (3) elektrisch verbunden ist, und
wobei eine jeweilige andere Seite der Y-Kondensatoren (CY) des mindestens einen Paares (4) mit jeweils einer Massestromschiene (5,6) elektrisch verbunden ist.

2. Zwischenkreiskondensatoranordnung (1) nach Anspruch 1, **dadurch gekennzeichnet, dass** eine Anordnung der Y-Kondensatoren (CY) des mindestens einen Paares (4) zwischen den Plus- und Minusstromschienen (2,3) symmetrisch ist.

3. Zwischenkreiskondensatoranordnung (1) nach einem der vorangegangenen Ansprüche, **dadurch gekennzeichnet, dass** die aneinander gestapelten Y-Kondensatoren (CY) des mindestens einen Paares(4) in einer von der Plus-Stromschiene (2) zur Minus-Stromschiene (3) verlaufenden Erstreckungsrichtung (7) zusammen die gleiche Größe aufweisen wie der mindestens eine X-Kondensator (CX).

4. Zwischenkreiskondensatoranordnung (1) nach einem der vorangegangenen Ansprüche, **dadurch gekennzeichnet, dass** das mindestens eine Paar (4) Y-Kondensatoren (CY) direkt benachbart zu dem mindestens einen X-Kondensator (CX) angeordnet ist.

5. Zwischenkreiskondensatoranordnung (1) nach einem der vorangegangenen Ansprüche, **dadurch gekennzeichnet, dass** zwei Paare (4) Y-Kondensatoren (CY) vorgesehen sind, wobei je eines der Paare (4) an einem der Enden (8) der Plus- und Minus-Stromschienen (2,3) angeordnet ist.

6. Zwischenkreiskondensatoranordnung (1) nach einem der vorangegangenen Ansprüche, **dadurch gekennzeichnet, dass** die Massestromschiene (5) des einen der Y-Kondensatoren (CY) des mindestens einen Paares (4) mit der Massestromschiene (6) des anderen der Y-Kondensatoren (CY) des mindestens einen Paares (4) verschweißt ist, wobei nur die Massestromschiene (6) des anderen Y-Kondensators (CY) nach außen geführt ist.

7. Zwischenkreiskondensatoranordnung (1) nach einem der Ansprüche 1 bis 5, **dadurch gekennzeichnet, dass** die Massestromschienen (5,6) der Y-Kondensatoren (CY) des mindestens einen Paares (4) parallel zueinander nach außen geführt sind.

8. Zwischenkreiskondensatoranordnung (1) nach einem der vorangegangenen Ansprüche, **dadurch gekennzeichnet, dass** die Y-Kondensatoren(CY) in einer Richtung parallel zu einer Längserstreckungsrichtung (11) der Plus- und Minusstromschienen (2,3) eine geringere Größe aufweisen als senkrecht hierzu.

9. Zwischenkreiskondensatoranordnung (1) nach einem der vorangegangenen Ansprüche, **dadurch gekennzeichnet, dass** der mindestens eine X-Kondensator (CX) und das mindestens eine Paar (4) Y-Kondensatoren (CY) in einem gemeinsamen Kunststoffgehäuse (12) gehaust sind und/oder mit Epoxidharz (13) vergossen sind.

10. Leistungselektronische Anordnung (20), umfassend:
eine Zwischenkreiskondensatoranordnung (1) nach einem der Ansprüche 1 bis 9, und mindestens ein Leistungsmodul (10), wobei das mindestens eine Leistungsmodul (10) zwischen den Enden (8) der Plus-Stromschiene (2) und der Minus-Stromschiene (3) angeordnet ist und mit der Plus-Stromschiene (2) und der Minus-Stromschiene (3) elektrisch verbunden ist.

11. Verfahren zum Betreiben einer Zwischenkreiskondensatoranordnung (1),
wobei mindestens ein X-Kondensator (CX) elektrisch verbunden mit einer Plus-Stromschiene (2) und einer Minus-Stromschiene (3) betrieben wird, und
wobei mindestens ein Paar (4) Y-Kondensatoren (CY) aneinander gestapelt zwischen den Stromschienen (2,3) angeordnet betrieben wird, wobei einer der Y-Kondensatoren (CY) des mindestens einen Paares (4) mit der Plus-Stromschiene (2) und ein anderer der Y-Kondensatoren (3) des mindestens einen Paares (4) mit der Minus-Stromschiene (3) elektrisch verbunden ist, und wobei eine jeweilige andere Seite der Y-Kondensatoren (CY) des mindestens einen Paares (4) mit jeweils einer Massestromschiene (5,6) elektrisch verbunden ist.
